# DEMANDE DE BREVET EUROPEEN

(11) **EP 0 949 667 A1**
(43) Date de publication de la demande: **13.10.1999**
(21) Numéro de dépôt: 99410021.2
(22) Date de dépôt: 26.03.1999
(51) Int. Cl.: H01L 21/336, H01L 29/788

(54) **Cellule mémoire électriquement programmable**

(30) Priorité: 26.03.1998 FR 9804005
(71) Demandeur: STMicroelectronics SA, 94250 Gentilly Cedex (FR)
(72) Inventeur: Borel, Joseph, 38120 Saint Egrève (FR); Schoellkopf, Jean-Pierre, 38000 Grenoble (FR); Papadas, Constantin, 38610 Gières (FR)
(74) Mandataire: de Beaumont, Michel

(57) **Abrégé**

L'invention concerne un procédé de fabrication d'une cellule mémoire électriquement programmable à grille flottante latérale par rapport à la grille de commande, comprenant les étapes consistant à former une grille de commande isolée (4) sur une zone active ; former une couche mince isolante (5) autour de la grille de commande ; déposer successivement une couche mince d'un matériau conducteur (21) et une couche d'un matériau isolant ; graver de façon anisotrope le matériau isolant pour former des espaceurs (23, 24) de ce matériau ; et éliminer les parties de la couche mince conductrice (21) non revêtues des espaceurs.

## Description

La présente invention concerne le domaine des cellules mémoire réalisables en technologie MOS.

Plus particulièrement, la présente invention concerne une cellule mémoire comportant une grille de commande et une grille flottante dans laquelle la grille flottante est disposée latéralement par rapport à la grille de commande.

Le brevet des Etats-Unis d'Amérique N° 5687113 (B2408) au nom de Constantin Papadas et Bernard Guillaumot, cédé à la demanderesse, décrit une telle cellule dans laquelle la grille flottante est disposée latéralement par rapport à la grille de commande.

La figure 1 représente une cellule mémoire du type de celle décrite dans le brevet susmentionné. La cellule est formée dans un substrat de silicium monocristallin 1, plus particulièrement dans une zone active de ce substrat délimitée par une couche d'oxyde épais 2. La surface supérieure du substrat semiconducteur est revêtue d'une couche mince d'oxyde de silicium 3 sur laquelle est formée une grille de commande en silicium polycristallin 4. Les parois latérales de la grille de silicium polycristallin sont isolées par une couche d'oxyde de silicium 5 et des espaceurs de silicium polycristallin 7 et 8 sont formés de part et d'autre de la grille. Dans le brevet susmentionné, les espaceurs latéraux conducteurs 7 et 8 sont formés au-dessus de zones respectives d'extension de source et de drain 9 et 10. Par exemple, si le substrat est de type P, les extensions de source et de drain sont de type N. En outre, la cellule comprend des zones de source et de drain 11 et 12 de type N⁺ plus fortement dopées.

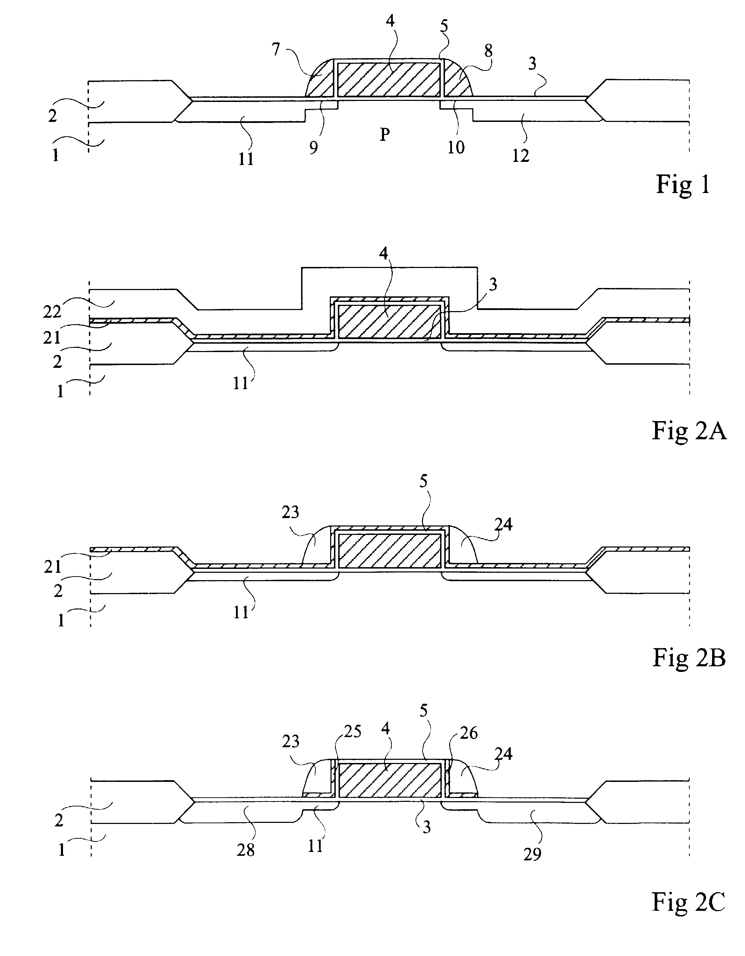

Bien entendu, la cellule illustrée en figure 1 n'est pas achevée. Pour la terminer, il reste à établir des contacts avec les régions de source, de drain et de grille de commande. Eventuellement, la cellule comprend un seul espaceur latéral 8 au-dessus d'une extension de drain.

La cellule de ce brevet antérieur de la demanderesse donne des résultats satisfaisants. Toutefois, elle n'est pas compatible avec toutes les technologies de fabrication de circuits intégrés MOS et nécessite un double niveau de couches de silicium polycristallin, le premier niveau correspondant à la grille de commande et le deuxième niveau correspondant à une couche à partir de laquelle on a formé les espaceurs 7 et 8.

Ainsi, la présente invention vise à prévoir une cellule mémoire électriquement programmable dans laquelle la grille flottante est latérale par rapport à la grille de commande et qui soit particulièrement simple à fabriquer par des procédés compatibles avec des procédés de fabrication de structures CMOS.

Pour atteindre ces objets, la présente invention prévoit un procédé de fabrication d'une cellule mémoire électriquement programmable à grille flottante latérale par rapport à la grille de commande, comprenant les étapes consistant à former une grille de commande isolée sur une zone active ; former une couche mince isolante autour de la grille de commande ; déposer successivement une couche mince d'un matériau conducteur et une couche d'un matériau isolant ; graver de façon anisotrope le matériau isolant pour former des espaceurs de ce matériau ; et éliminer les parties de la couche mince conductrice non revêtues des espaceurs.

Selon un mode de réalisation de la présente invention, le matériau conducteur est du silicium polycristallin dopé.

Selon un mode de réalisation de la présente invention, le matériau conducteur a une épaisseur de 5 à 20 nm.

Selon un mode de réalisation de la présente invention, le matériau isolant est du nitrure de silicium.

Selon un mode de réalisation de la présente invention, le procédé comprend en outre l'étape consistant à oxyder les parties apparentes des régions conductrices.

La présente invention concerne aussi une cellule mémoire à grille de commande et grille flottante latérale, comprenant sur les parois latérales de la grille de commande des espaceurs isolants sous lesquels est disposée une couche mince d'un matériau conducteur.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 représente une structure de cellule mémoire électriquement programmable à espaceurs latéraux selon l'art antérieur ; et
les figures 2A à 2C représentent des étapes successives de fabrication d'une cellule mémoire électriquement programmable à grille flottante latérale selon la présente invention.

Dans le procédé selon la présente invention, comme dans le procédé selon l'art antérieur, la cellule est formée dans une zone active d'un substrat de silicium monocristallin 1 délimitée par une région d'oxyde épais 2. Cette région d'oxyde épais peut être formée par tout moyen et d'autres procédés d'isolement d'une zone active pourront être utilisés.

Comme l'illustre la figure 2A, on forme une grille conductrice isolée 4 sur une couche d'isolement de grille 3, couramment une couche d'oxyde de silicium. Eventuellement, immédiatement après la formation de la grille, on forme des régions de source et de drain faiblement dopées en se servant de la grille et de l'oxyde épais comme masque. On notera que, selon une variante, on peut omettre cette étape de formation de régions de source et de drain faiblement dopées.

Ensuite, selon la présente invention, on forme sur la couche d'oxyde 3 une couche mince d'un matériau conducteur 21. Cette couche mince peut par exemple avoir une épaisseur de l'ordre de seulement 5 à 20 nm, par exemple 10 nm. Le matériau conducteur peut être du silicium polycristallin, dopé in situ ou dopé par une implantation ultérieure, ou un métal. On dépose ensuite une couche d'un isolant épais, de préférence du nitrure de silicium 22.

A l'étape représentée en figure 2B, on procède à une gravure anisotrope de la couche de nitrure de silicium 22 pour laisser en place seulement des espaceurs 23 et 24.

A une étape ultérieure représentée en figure 2C, on élimine la couche mince 21 de matériau conducteur partout où elle n'est pas recouverte par les espaceurs 23 et 24 pour laisser en place seulement des régions en forme de L 25 et 26. Cette élimination peut être réalisée en prolongeant la gravure réalisée pour former les espaceurs 23 et 24. De préférence, l'étape de la figure 2C est suivie d'une étape d'oxydation pour oxyder et rendre isolantes les surfaces apparentes des régions en forme de L 25 et 26 constituant une grille flottante. Ceci est possible si le matériau conducteur dont est formée la couche 21 est un matériau oxydable tel que du silicium polycristallin ou un métal convenablement choisi, par exemple de l'aluminium. Cet isolement par oxydation permet d'éviter tout court-circuit avec des métallisations formées ultérieurement. On a également représenté en figure 2C la formation de zones de drain et de source 28 et 29. On réalisera ensuite de façon classique des contacts de drain, de source et de grille de commande.

Le mode de fonctionnement de la cellule selon la présente invention ne sera pas décrit en détail puisqu'il est identique à celui décrit dans le brevet américain susmentionné. On notera que la prévision d'une couche conductrice très mince est suffisante pour assurer la fonction de grille flottante.

Bien entendu, la présente invention est susceptible de diverses variantes et modifications qui apparaîtront à l'homme de l'art. En particulier, comme cela a été indiqué précédemment, les grilles flottantes ne sont pas nécessairement disposées au-dessus de régions d'extension de source et de drain. D'autre part, l'isolant disposé sous les grilles flottantes sera, selon le type de mémoire que l'on souhaite réaliser, d'une épaisseur propre à fonctionner par effet tunnel ou non. On pourrait également prévoir une structure symétrique ou dissymétrique comme cela a été exposé dans le brevet susmentionné. De plus, bien que le matériau isolant disposé sous la grille flottante ait été décrit précédemment comme étant un oxyde de silicium, d'autres matériaux isolants ou combinaisons de matériaux isolants pourront être utilisés.

## Revendications

1. Procédé de fabrication d'une cellule mémoire électriquement programmable à grille flottante latérale par rapport à la grille de commande, caractérisé en ce qu'il comprend les étapes suivantes :
former une grille de commande isolée (4) sur une zone active ;
former une couche mince isolante (5) autour de la grille de commande ;
déposer successivement une couche mince d'un matériau conducteur (21) et une couche d'un matériau isolant (22) ;
graver de façon anisotrope le matériau isolant pour former des espaceurs (23, 24) de ce matériau ; et
éliminer les parties de la couche mince conductrice (21) non revêtues des espaceurs.

2. Procédé selon la revendication 1, caractérisé en ce que le matériau conducteur est du silicium polycristallin dopé.

3. Procédé selon la revendication 1 ou 2, caractérisé en ce que le matériau conducteur a une épaisseur de 5 à 20 nm.

4. Procédé selon la revendication 1, caractérisé en ce que le matériau isolant est du nitrure de silicium.

5. Procédé selon la revendication 1, caractérisé en ce qu'il comprend en outre l'étape consistant à oxyder les parties apparentes des régions conductrices.

6. Cellule mémoire à grille de commande et grille flottante latérale, caractérisée en ce qu'elle comprend sur les parois latérales de la grille de commande des espaceurs isolants (23, 24) sous lesquels est disposée une couche mince (25, 26) d'un matériau conducteur.
